# EUROPEAN PATENT APPLICATION

(11) **EP 1 498 940 A2**
(43) Date of publication of application: **19.01.2005**
(21) Application number: 04016212.5
(22) Date of filing: 09.07.2004
(51) Int. Cl.: H01L 21/311, C07C 17/00

(54) **Use of hypofluorites, fluoroperoxides, and/or fluorotrioxides as oxidizing agent in fluorocarbon etch plasmas**

(30) Priority: 15.07.2003 US 619922
(71) Applicant: AIR PRODUCTS AND CHEMICALS, INC., Allentown, PA 18195-1501 (US)
(72) Inventor: Ji, Bing, Allentown PA 18104 (US); Motika, Stephen Andrew, Kutztown PA 19530 (US); Syvret, Robert George, Allentown PA 18103-5451 (US); Badowski, Peter R., White Haven PA 18661 (US); Karwacki, Eugene Joseph Jr., Orefield PA 18069 (US); Withers, Howard Paul, Jr., Breinigsville PA 18031 (US); Pearlstein, Ronald Martin, Macungie PA 18062 (US)
(74) Representative: Schwabe - Sandmair - Marx

(57) **Abstract**

A mixture and a method comprising same for etching a dielectric material from a layered substrate are disclosed herein. Specifically, in one embodiment, there is provided a mixture for etching a dielectric material in a layered substrate comprising: a fluorocarbon gas, a fluorine-containing oxidizer gas selected from the group consisting of a hypofluorite, a fluoroperoxide, a fluorotrioxide, and combinations thereof; and optionally an inert diluent gas. The mixture of the present invention may be contacted with a layered substrate comprising a dielectric material under conditions sufficient to form active species that at least partially react with and remove at least a portion of the dielectric material.

## Description

### BACKGROUND OF THE INVENTION

Dielectric materials are principally used for forming electrically insulating layers within, for example, an electronic device or integrated circuits (IC). Selective anisotropic etching of dielectric materials is the process step extensively used to produce features in the manufacturing of integrated circuits (IC), microelectromechanical systems (MEMS), optoelectronic devices, and micro-optoelectronic-mechanical systems (MOEMS).

Device features on a wafer are typically defined by patterned masks. These patterned masks are generally composed of an organic photoresist material; however "hard" mask materials, such as silicon nitride Si₃N₄, or other material that may be etched at a slower rate than the dielectric material, may also be used as the mask material. Selective anisotropic etching allows for the formation of features such as contact and via holes by removing at least a portion of the underlying dielectric material while essentially preserving the patterned mask. The dielectric materials to be selectively removed from under the mask openings include: silicon in its various forms such as crystalline silicon, polysilicon, amorphous silicon, and epitaxial silicon; compositions containing silicon such as silicon dioxide (SiO₂); undoped silicate glass (USG); doped silicate glass such as boron doped silicate glass (BSG); phosphorous doped silicate glass (PSG), and borophosphosilicate glass (BPSG); silicon and nitrogen containing materials such as silicon nitride (Si₃N₄), silicon carbonitride (SiCN) and silicon oxynitride (SiON); and materials having a low dielectric constant (e.g., having a dielectric constant of 4.2 or less) such as fluorine doped silicate glass (FSG), organosilicate glass (OSG), organofluoro-silicate glass (OFSG), polymeric materials such as silsesquioxanes (HSQ, HSiO_{1.5}) and methyl silsesquioxanes (MSQ, RSiO_{1.5} where R is a methyl group), and porous low dielectric constant materials.

Some of the key manufacturing requirements for selective anisotropic dielectric etching include: high etch rate of the underlying dielectric materials; zero or low loss of the patterned mask, i.e., high etch selectivity of the dielectric material over the mask material; maintaining the critical dimensions of the patterned mask; maintaining desired etch profile, i.e. high anisotropy; maintaining uniformity across the wafer; minimal variation over feature sizes and density, i.e., no microloading effects; high selectivity over underlying etch stop layer such as SiC, SiN, and silicon etc.; and sidewall passivation films that can be easily removed in post-etch ashing, stripping and/or rinsing. Of the foregoing requirements, achieving high etch selectivity of the dielectric materials over the mask material and maintaining the critical dimensions of the patterned mask may be the most important yet the most challenging performance requirements to obtain.

As the IC geometry shrinks, newer photoresist materials are increasingly being adopted for deep ultraviolet (DUV) photolithography at sub-200 nm, i.e., 193 nm, wavelengths. DUV photoresist materials are generally less resistant to plasma etching than older-generation photoresist materials. Further, the thickness of the DUV photoresist is typically only a few hundreds of nanometers, and in some instances less than 200 nm, because of the absorptivity of DUV light by the resist materials. Because of the limits set by dielectric break-down, the thickness of the dielectric layer are generally not reduced below 0.5 to 1 µm. However, the minimum feature sizes of the contact and via holes penetrating the dielectric layer may be below 0.5 µm. As a result, the holes etched within the dielectric material need to be highly anisotropic and have high aspect ratios (HAR), defined as the ratio of the depth to the minimum width of a hole. High aspect ratio (HAR) etching of dielectric materials may require via/trench depth of over several micrometers or an order of magnitude higher than the thickness of the DUV. The further evolution of photolithography technology to lower wavelengths, i.e., 157 nm and EUV photolithography, may lead to the need for even higher etch selectivity between the underlying dielectric materials and the photoresist materials.

Fluorocarbon plasmas are commonly used for selective anisotropic etching of silicon-containing dielectric materials such as SiO₂. The fluorocarbons used for selective anisotropic etching include: CF₄ (tetrafluoromethane), CHF₃ (trifluoromethane), C₄F₈ (octafluorocyclobutane), C₅F₈ (octafluorocyclopentene), and C₄F₆ (hexafluoro-1,3-butadiene). These fluorocarbons dissociate in plasma to form reactive fluorocarbon species, such as, for example CF, CF₂, C₂F₃ etc. The fluorocarbon species may provide the reactive source of fluorine to etch the underlying silicon-containing dielectric materials in the presence of, for example, energetic ion bombardment. Further, the fluorocarbon species may form a fluorocarbon polymer that protects the photoresist and the sidewalls of the etch features which is referred to herein as the polymerization reaction.

For selective anisotropic etching applications, the substrate typically contains one or more dielectric layers covered with a patterned photoresist coating to provide a feature such as a contact or via hole within the dielectric material. Depending on factors such as location, substrate chemistry, ion fluxes, etc., the fluorocarbon polymer may initiate distinctly different plasma-surface chemical reactions. For example, the fluorocarbon polymer may form a protective layer against sputtering damage of argon ions and/or other reactive species in the plasma at the photoresist surface. By contrast, the presence of oxygen within the dielectric material and high energy ions impinging upon the exposed dielectric surface may facilitate the formation of volatile species which is referred to herein as the etch reaction. The volatile species formed from the etch reaction can be readily removed from the reactor via vacuum pump or other means. However, the etch reaction does not typically occur on the sidewall surfaces of vias or trenches since there is no ion bombardment impinging upon the vertical surfaces. Therefore, the fluorocarbon polymer may provide a protective or passivation layer on the unexposed dielectric material such as feature sidewalls whereas the etch reaction of the fluorocarbon polymer with the exposed dielectric forms volatile species thereby removing the dielectric material. Thus, at the dielectric surface, the end-product of the polymerization reaction, or the fluorocarbon polymer, serves as source for the reactive fluorine in the etch reaction, provided that it can be adequately removed so that no fluorocarbon polymer accumulates on the exposed dielectric surface thereby impeding the etching process.

To protect the exposed photoresist surface, it may be desirable to have a fluorocarbon plasma that is highly polymerizing to encourage the formation of the fluorocarbon polymer. However, at the exposed dielectric surface, if the etch reaction cannot compete with the polymerization reaction, the thin fluorocarbon film can accumulate and the etch process may stop. To optimize the competing reactions of etching and polymerization, molecular oxygen (O₂) is routinely added to the fluorocarbon etch plasma. The etch rate of the dielectric material may be increased if an optimal balance between the competing reactions can be achieved. Unfortunately, O₂ can attack the organic photoresist materials thereby increasing the photoresist etch rate. This may result in the undesirable decrease of etch selectivity of the dielectric material over the photoresist material within the substrate.

Over the years, the preferred fluorocarbon gases for selective anisotropic dielectric etching have evolved from a mixture of CF₄ and CHF₃, to C₄F₈, recently to C₅F₈, and more recently to C₄F₆. Until now, molecular oxygen (O₂) has been used as the oxidizer to fine-tune fluorocarbon plasmas to achieve the optimized balance between high etch rate of dielectric materials and high etch selectivity of dielectric over photoresist materials. However, the IC industry is approaching the limit of the O₂/fluorocarbon chemistry for the most demanding selective anisotropic HAR dielectric etching at deep micron feature sizes.

The prior art provides some alternatives to traditionally used fluorocarbons for various etching and/or cleaning applications. For example, European Patent Application EP 0924282 describes the use of hypofluorites by themselves or in a mixture with an inert gas, a hydrogen or hydrogen-containing gas (e.g., HI, HBr, HCl, CH₄, NH₃, H₂, C₂H₂, and C₂H₆), and/or an oxygen or oxygen-containing gas (i.e., CO, NO, N₂O, and NO₂) as a replacement for fluorocarbon gases. Japanese Patent Application JP 2000/038581A describes the use of bis-trifluoromethyl peroxide as an etch gas by itself or in a mixture containing a hydrogen or hydrogen-containing gas. Japanese Patent Applications JP 2000/038675A and JP 2002/184765A describe the use of bis-trifluoromethyl peroxide, fluoroxytrifluoromethane (FTM), or bis-(fluoroxy)difluoromethane (BDM) as a cleaning gas to remove deposits from CVD chambers. Despite these alternatives, there remains a need in the art for a new etch chemistry that can provide a higher etch rate of dielectric materials along with a higher etch selectivity of dielectric materials over photoresist masks.

All references cited herein are incorporated herein by reference in their entireties.

### BRIEF SUMMARY OF THE INVENTION

The present invention satisfies one, if not all, of the needs in the art by providing a mixture and a method comprising same for removing at least a portion of a dielectric material from a layered substrate. Specifically, in one aspect of the present invention, there is provided a mixture for etching a dielectric material in a layered substrate comprising: a fluorocarbon and an oxidizer selected from the group consisting of a hypofluorite, a fluoroperoxide, a fluorotrioxide, and combinations thereof.

In another aspect of the present invention, there is provided a mixture for etching a dielectric material in a layered substrate comprising: a fluorocarbon and a hypofluorite.

In a further aspect of the present invention, there is provided a mixture for etching a dielectric material in a layered substrate comprising: a fluorocarbon and a fluoroperoxide.

In yet another aspect of the present invention, there is provided a mixture for etching a dielectric material in a layered substrate comprising: a fluorocarbon and a fluorotrioxide.

In a still further aspect of the present invention, there is provided a method for the removal of a portion of a dielectric material from a layered substrate comprising: placing the layered substrate within a reaction chamber; providing a gas mixture comprising a fluorocarbon gas and an oxidizer gas selected from the group consisting of a hypofluorite, a fluoroperoxide, a fluorotrioxide, and combinations thereof; applying energy to the gas mixture to form active species; and contacting the layered substrate with the active species wherein the active species react with and remove the portion of the dielectric material.

In another aspect of the present invention, there is provided a method for etching at least a portion of a dielectric material from a layered substrate comprising: contacting the layered substrate with the active species of a mixture comprising a fluorocarbon, an oxidizer selected from the group consisting of a hypofluorite, a fluoroperoxide, a fluorotrioxide, and combinations thereof, wherein the active species at least partially reacts with and removes at least a portion of the dielectric material.

These and other aspects of the present invention will be more apparent from the following description.

### BRIEF DESCRIPTION OF SEVERAL VIEWS OF THE DRAWINGS

Figure 1 provides an illustration of an apparatus used in one embodiment of the method of the present invention.

Figure 2 provides an example of a layered substrate.

Figure 3 provides a Scanning Electron Microscopy (SEM) image of a 0.35 µm via that was etched using one embodiment of the method of the present invention.

Figure 4 provides a SEM image of a 0.5 µm via that was etched using one embodiment of the method of the present invention.

Figure 5 provides a SEM image of a 0.35 µm via that was etched using a comparative method.

Figure 6 provides a SEM image of a 0.5 µm via that was etched using a comparative method.

Figure 7 provides a SEM image of a 0.3 µm that was etched using one embodiment of the method of the present invention.

### DETAILED DESCRIPTION OF THE INVENTION

The present invention provides a mixture and a method comprising same for the removal of a substance from a layered substrate, that uses a fluorine-containing oxidizer such as hypofluorites, fluoro-peroxides, and/or fluoro-trioxides to decrease the amount of, or replace, molecular oxygen (O₂) as the oxidizer, in conjunction with one or more fluorocarbons. The mixture and the method of the present invention may be used, for example, for selective anisotropic etching of a dielectric material from a layered substrate. In certain preferred embodiments, the mixture may be exposed to one or more energy sources sufficient to form active species, which then react with and remove the substance from the substrate.

In the present invention, it is believed that the use of a fluorine-containing oxidizer such as a hypofluorite, a fluoroperoxide, and/or a fluorotrioxide may be used in place of some, if not all of the O₂, thereby preventing the erosion of the mask or photoresist material. Further, the fluorine-containing oxidizer may increase the dielectric etch rate by providing additional fluorine atoms into the etch reaction and subsequently the dielectric surface. Thus, the use of hypofluorites, fluoro-peroxides, and/or fluorotrioxides to replace or significantly reduce the use of O₂ as the oxidizer in a mixture containing at least one fluorocarbon may enhance both the etch rate of dielectric materials and the etch selectivity of dielectric materials over photoresist materials.

As mentioned previously, the mixture of the present invention comprises the following reagents: at least one fluorocarbon and a fluorine-containing oxidizer such as a hypofluorite, a fluoroperoxide, and/or a fluorotrioxide. Although the reactive agents and mixture used herein may be sometimes described herein as "gaseous", it is understood that the reagents may be delivered directly as a gas to the reactor, delivered as a vaporized liquid, a sublimed solid and/or transported by an inert diluent gas into the reactor.

The mixture of the present invention contains one or more fluorocarbon gases in conjunction with the one or more fluorine-containing oxidizer. The term "fluorocarbon " as used herein includes perfluorocarbons (compounds containing C and F atoms), hydrofluorocarbons (compounds containing C, H, and F), oxyhydrofluorocarbons (compounds containing C, H, O, and F), and oxyfluorocarbons (compounds containing C, O, and F). In one embodiment, the perfluorocarbon is a compound having the formula CₕFᵢ wherein h is a number ranging from 1 to 10 and i is a number ranging from h to 2h+2. Examples of perfluorocarbons having the formula CₕFᵢ include, but are not limited to, CF₄ (tetrafluoromethane), C₄F₈ (octafluorocyclobutane), C₅F₈ (octafluorocyclopentene), and C₄F₆ (hexafluoro-1,3-butadiene). In another embodiment, the fluorocarbon is a hydrofluorocarbon compound having the formula CⱼHₖFₗ wherein j is a number from 1 to 10, and k and l are positive integers with (k + l) from j to 2j + 2. An example of a hydrofluorocarbon compound having the formula CⱼHₖFₗ includes CHF₃ (trifluoromethane). In other embodiments, the fluorocarbon is an oxyfluorocarbon or a oxyhydrofluorocarbon. Examples of oxyfluorocarbon compounds include perfluorocyclopentene oxide, hexafluoro-cyclobutanone, hexafluorodihydrofuran, hexafluorobutadiene epoxide, tetrafluorocyclobutanedione perfluorotetrahydrofuran (C₄F₈O), hexafluoropropylene oxide (C₃F₆O), perfluoromethylvinyl ether (C₃F₆O), and combinations thereof. An example of a oxyhydrofluorocarbon compound includes heptafluorocyclobutanol. The amount of fluorocarbon gas present in the mixture may range from 1 to 99%, preferably from 1 to 50%, and more preferably from 2 to 20% by volume.

In certain embodiments of the present invention, it may be preferable to use a fluorocarbon with a lower ratio of fluorine atoms to carbon atoms, referred to herein as F/C ratio, within the molecule. By using fluorocarbons with a lower F/C ratio, it is believed that the etch plasmas can form fluorocarbon polymers having a higher degree of cross-linking. Highly cross-linked fluorocarbon polymers may be more resistant to the etch reaction thereby providing better protection to the photoresist layer and sidewalls. However, other fluorocarbons having a F/C of 2 or greater may also be used.

In addition to the one or more fluorocarbons, the mixture of the present invention contains at least one fluorine-containing oxidizer gas selected from the group consisting of a hypofluorite, a fluoroperoxide, a fluorotrioxide, or a combination thereof. A hypofluorite, as described herein, refers to a molecule that contains at least one -O-F group. The hypofluorite preferably is a compound having the formula CₓH_{y}F_{z}(OF)ₙOₘ wherein x is a number ranging from 0 to 8, y is a number ranging from 0 to 17, z is a number ranging from 0 to 17, n is 1 or 2, and m is 0, 1, or 2. Examples of hypofluorites include fluoroxytrifluoromethane (FTM, CF₃-O-F), methylhypofluorite (CH₃OF), hypofluorous acid (HOF), trifluoroacetyl hypofluorite (CF₃C(O)OF), acetyl hypofluorite (CH₃C(O)OF), and bis-(fluoroxy)difluoromethane (BDM, F-O-CF₂-O-F). A fluoroperoxide, as described herein, is a molecule that contains at least one -O-O- group and where some if not all of the hydrogen atoms in the molecule are replaced with fluorine atoms. Examples of fluoro-peroxides include F-O-O-F (difluoro-peroxide), CF₃-O-O-F (fluoro-trifluoromethyl-peroxide), CF₃-O-O-CF₃ (bis-trifluoromethyl peroxide), CF₃-O-O-C₂F₅ (pentafluoroethyl-trifluoromethyl-peroxide), C₂F₅-O-O-C₂F₅ (bis-pentafluoroethyl-peroxide), CF₂O₂ (difluorodioxirane), CF₃OC(O)OOC(O)OCF₃ (bis-trifluoromethyl peroxydicarbonate), and CF₃-O-O-C(O)F (fluoroformyl trifluoromethyl peroxide), and FC(O)-O-O-C(O)F (bis-fluoroformyl-peroxide). A fluoro-trioxide, as described herein, is a molecule that contains at least one -O-O-O- group and where some or all of the hydrogen atoms in the molecule are replaced with fluorine atoms. Examples of fluorotrioxides include CF₃-O-O-O-CF₃ (bis-trifluoromethyl-trioxide), CF₃-O-O-O-F (fluorotrifluoromethyl-trioxide), and CF₃-O-O-O-C(O)F (fluoroformyl trifluoromethyl-trioxide). The amount of fluorine-containing oxidizer gas present in the mixture may range from 1 to 99%, preferably from 1 to 75%, and more preferably from 1 to 50% by volume. The ratio by volume of the fluorine-containing oxidizer gas to fluorocarbon gas within the mixture may range from 0.1:1 to 20:1, preferably from 0.1:1 to 10:1, and more preferably from 0.1:1 to 5:1.

In addition to the reactive agents described herein, inert diluent gases such as argon, nitrogen, helium, neon, krypton, xenon or combinations thereof can also be added. Inert diluent gases can, for example, modify the plasma characteristics to better suit some specific applications. In addition, ions from inert gases such as, for example, argon may provide the energetic bombardment to facilitate the selective anisotropic etch reactions. The concentration of the inert gas within the mixture can range from 0 to 99%, preferably from 25 to 99%, and more preferably from 50 to 99% by volume.

In some embodiments, the mixture may further comprise an oxidizer such as, for example, O₂, O₃, CO, CO₂, and N₂O. In these embodiments, the amount of oxidizer present in the mixture may range from 0 to 99 %, preferably from 0 to 75 %, and more preferably from 0 to 50 % by volume.

The chemical reagents can be delivered to the reaction chamber by a variety of means, such as, for example, conventional cylinders, safe delivery systems, vacuum delivery systems, solid or liquid-based generators that create the chemical reagent and/or the gas mixture at the point of use (POU). In one embodiment, the hypofluorites, fluoroperoxides, and/or fluorotrioxides, can be delivered to the reaction chamber via a compressed gas cylinder. In an alternative example, the chemical reagent such as the hypofluorite FTM can be generated at the point of use through, for example, the reaction of 1 or 2 molar equivalents of fluorine gas (F₂) with COF₂ or CO, respectively, in the presence of a catalyst. The hypofluorite BDM can be generated at the point of use through the reaction of 2 molar equivalents of fluorine gas with CO₂ in the presence of a catalyst. The source of F₂ and COF₂ in the foregoing reactions can be from a compressed cylinder, a safe delivery system, or a vacuum delivery system. Additionally, F₂ can be generated at the point of use via electrolytic dissociation of 2 molar equivalents of HF to form H₂ and F₂.

The process of the invention is useful for etching substances such as a dielectric material from a substrate. Suitable substrates that may be used include, but are not limited to, semiconductor materials such as gallium arsenide ("GaAs"), boron nitride ("BN"), silicon in its various forms such as crystalline silicon, polysilicon, amorphous silicon, and epitaxial silicon, compositions containing silicon such as silicon dioxide ("SiO₂"), silicon carbide ("SiC"), silicon oxycarbide ("SiOC"), silicon nitride ("SiN"), silicon carbonitride ("SiCN"), organosilicate glasses ("OSG"), organofluorosilicate glasses ("OFSG"), fluorosilicate glasses ("FSG"), and other appropriate substrates or mixtures thereof. Substrates may further comprise a variety of layers that include, for example, anti reflective coatings, photoresists, organic polymers, porous organic and inorganic materials, metals such as copper and aluminum, or diffusion barrier layers, e.g., TiN, Ti(C)N, TaN, Ta(C)N, Ta, W, WN, or W(C)N.

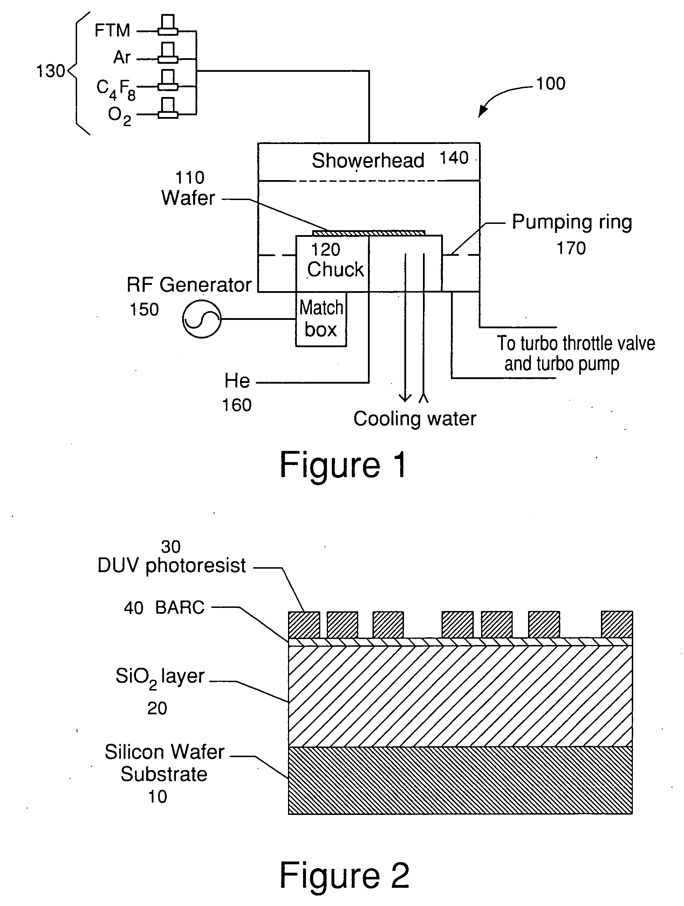

Figure 2 provides an example of a layered silicon wafer substrate 10 that is suitable for etching using the method of the present invention. Substrate 10 has a dielectric layer 20 such as SiO₂ deposited thereupon. A mask layer 30 such as a DUV photoresist is applied to dielectric layer 20 atop a back-side anti-reflective coating (BARC). Mask or photoresist layer 30 is depicted as being patterned. A patterned photoresist is typically formed by exposing the substrate to a radiation source to provide an image, and developing the substrate to form a patterned photoresist layer on the substrate. This patterned layer then acts as a mask for subsequent substrate patterning processes such as etching, doping, and/or coating with metals, other semiconductor materials, or insulating materials. The selective anisotropic etching process generally involves removing the portion of the substrate surface that is not protected by the patterned photoresist thereby exposing the underlying surface for further processing.

The mixture of the present invention is exposed to one or more energy sources sufficient to generate active species to at least partially react with the dielectric material and form volatile species. The energy source for the exposing step may include, but not be limited to, α-particles, β-particles, γ-rays, x-rays, high energy electron, electron beam sources of energy, ultraviolet (wavelengths ranging from 10 to 400 nm), visible (wavelengths ranging from 400 to 750 nm), infrared (wavelengths ranging from 750 to 10⁵ nm), microwave (frequency > 10⁹ Hz), radio-frequency wave (frequency > 10⁶ Hz) energy; thermal, RF, DC, arc or corona discharge, sonic, ultrasonic or megasonic energy, and combinations thereof.

In one embodiment, the mixture is exposed to an energy source sufficient to generate a plasma having active species contained therein. Specific examples of using the plasma for etching processes include, but are not limited to, reactive ion etch (RIE), magnetically enhanced reactive ion etch (MERIE), a inductively coupled plasma (ICP) with or without a separate bias power source, transformer coupled plasma (TCP), hollow anode type plasma, helical resonator plasma, electron cyclotron resonance (ECR) with or without a separate bias power source, RF or microwave excited high density plasma source with or without a separate bias power source, etc. In embodiments wherein a RIE process is employed, the etching process is conducted using a capacitively coupled parallel plate reaction chamber. In these embodiments, the layered substrate (e.g., a patterned wafer) may be placed onto a RF powered lower electrode within a reaction chamber. The substrate is held onto the electrode by either a mechanical clamping ring or an electrostatic chuck. The backside of the substrate may be cooled with an inert gas such as helium. The RF power source may be, for example, an RF generator operating at a frequency of 13.56 MHz, however other frequencies can also be used. The RF power density can vary from 0.3 to 30 W/cm², preferably from 1 to 16 W/cm². The operating pressure can vary from 0.1 to 10,000 mTorr, preferably from 1 to 1000 mTorr, and more preferably from 1 to 100 mTorr. The flow rate of the mixture into the reaction chamber ranges from 10 to 50,000 standard cubic centimeters per minute (sccm), preferably from 20 to 10,000 sccm, and more preferably from 25 to 1,000 sccm.

The invention will be illustrated in more detail with reference to the following Examples, but it should be understood that the present invention is not deemed to be limited thereto.

### EXAMPLES

The following examples were conducted in two different etch reactors: a modified Gaseous Electronics Conference Reference Reactor ("GEC") plasma reactor and a commercial production scale Applied Materials P-5000 Mark II reactor. The experiments were conducted in a parallel plate capacitively coupled RF plasma reactor 100 similar to the setup illustrated in Fig. 1. For each experimental run, a substrate 110 was loaded onto the reactor chuck 120. Process gases 130 were fed into the reactor 100 from a top mounted showerhead 140. The chuck was then powered by a 13.56 MHz RF power source 150 to generate the plasma (not shown). The chuck has a helium backside cooling system 160. Volatile species (not shown) are removed from the reaction chamber 100 through a pumping ring 170 by a turbo pump (not shown). Pumping ring 170 creates an axially symmetric pathway to pump out the gases and volatile species contained therein.

The GEC reactor operates in a capacitively coupled reactive ion etcher (RIE) mode. A 100 mm wafer is placed onto the RF powered lower electrode, which has an effective RF "hot" surface area of about 182 cm². Chemical reagents such as FTM, Ar, C₄F₆, and O₂ flow through the showerhead into the reaction chamber. RF power at 13.56 MHz is delivered from an RF generator through an automatic matching network. The lower electrode assembly is equipped with an electrostatic chuck and helium backside cooling system. Typical helium backside cooling pressure on the GEC reactor 100 is servo-controlled at about 4 Torr. Like the GEC reactor, the Applied Materials P-5000 Mark II reactor also operates in capacitively coupled RIE mode, with magnetic confinement to increase plasma density and hence to improve etch rate and uniformity. This type of reactor is often termed as magnetically enhanced reactive ion etcher (MERIE). The Applied Materials Mark II reactor uses a clamping ring mechanical chuck and helium backside cooling at 8 Torr for processing 200 mm wafers. In both reactors, the wafer chuck is water cooled at 20°C.

Typical etch recipes may include a fluorocarbon etch gas, such as C₄F₆ (hexafluoro-1,3-butadiene) and/or molecular O₂ (comparative examples) or a fluorine-containing oxidizer gas such as FTM. To facilitate selective anisotropic etching, inert gases such as argon are often used as the diluent with the above etchants. In the following examples unless stated otherwise, the reactor was powered at 13.56 MHz at 1000 W, or approximately 3 W/cm² power density. This resulted in a typical direct current (DC) bias voltage of about -900V. The chamber pressure was kept at 35 mTorr. The magnetic field was set at 50 Gauss.

Scanning Electron Microscopy (SEM) was performed on a cross section of a piece of a cleaved patterned wafer fragment at a magnification of 35,000 times.

### Example 1: Unpatterned Wafer Etching Using FTM/C₄F₆/Ar Mixture on the GEC Reactor

A set of experiments was performed on the GEC plasma reactor under the following conditions: chamber pressure 35 mTorr, RF power 300 W at 13.56 MHz, or RF power density of 1.6 W/cm². In the GEC reactor, the RF power and pressure resulted in a DC self-bias voltage around -900 V. A 10 mole% quantity of C₄F₆ is used as the etch fluorocarbon gas with various FTM/C₄F₆ ratios in the experiments. In all recipes, the total feed gas flow rate is fixed at 110 standard cubic centimeter per minute (sccm) and the balance of the feed gas mixture is made of argon as the diluent. Silicon wafers coated with a 1 micrometer thick thermally grown SiO₂ film or about 400 nm thick 193 nm photoresist film were etched in the experiments. Film thicknesses were measured by reflectometer before and after the plasma exposure to determine the etch rate. Table 1 lists the results as a function of the FTM/C₄F₆ ratio.

Table 1 shows a trend that as the FTM/C₄F₆ ratio increases, both SiO₂ and photoresist etch rate increases so that the etch selectivity SiO₂/photoresist decreases. This trend is consistent with the general trend of increasing oxidizer/C₄F₆ ratio in fluorocarbon plasma etch.

**Table 1.**

| FTM/C₄F₆/Ar Unpatterned Wafer Etch Results on GEC Reactor | | | |
|---|---|---|---|
| FTM/C₄F₆ molar ratio | SiO₂ etch rate (nm/min) | Photoresist etch rate (nm/min) | SiO₂/photoresist etch selectivity |
| 2.00 | 101.2 | 22.3 | 4.50 |
| 2.25 | 118.2 | 28.2 | 4.20 |
| 2.50 | 129.8 | 32.4 | 4.00 |
| 2.80 | 136.3 | 41.5 | 3.30 |
| 3.10 | 143.9 | 48.2 | 3.00 |

### Comparative Example 2: Unpatterned Wafer Etching Using O₂/C₄F₆/Ar Mixture

As a comparison of relative performance, a series of experiments were conducted using conventional O₂/C₄F₆ chemistry on the GEC reactor. Except that O₂ is used as the oxidizer rather than FTM, all other processing conditions are the same as in Example 1. Table 2 lists the results as a function of O₂/C₄F₆ ratio.

It is evident from comparing the present example to example 1 that FTM/C₄F₆ chemistry offers both higher SiO₂ etch rate and higher SiO₂/photoresist etch selectivity under otherwise identical RF power, pressure, total flow rate, and C₄F₆ concentration. For example, at similar photoresist etch rate of about 20 nm/min, FTM/C₄F₆ chemistry showed about 50% higher SiO₂ etch rate, and about 40% higher SiO₂/photoresist etch selectivity.

**Table 2.**

| O₂/C₄F₆/Ar Unpatterned Wafer Etch Results on GEC Reactor | | | |
|---|---|---|---|
| O₂/C₄F₆ molar ratio | SiO₂ etch rate (nm/min) | Photoresist etch rate (nm/min) | SiO₂/photoresist etch selectivity |
| 1.25 | 66.0 | 20.3 | 3.2 |
| 1.50 | 93.6 | 31.2 | 3.0 |
| 1.75 | 99.5 | 41.2 | 2.4 |

### Comparative Example 3: Unpatterned Wafer Etching Using FTM/Ar Mixture without C₄F₆

To delineate the role of each gas component in Example 1, and to reveal the synergistic effects of FTM/C₄F₆ mixture, a series of experiments were conducted using only FTM diluted by argon on the GEC reactor. The same set of FTM flows were used as that in the Example 1 except that C₄F₆ was not fed into the reactor. All other processing conditions were the same as in Example 1. The results are shown in Table 3.

It is clearly evident that without C₄F₆, diluted FTM showed much higher etch rate for photoresist than that of SiO₂, resulting the etch selectivity of SiO₂/photoresist of only about 0.5. In fact, the etch rate of FTM without C₄F₆ is almost ten times of the etch rate of FTM with C₄F₆. Such high etch rate of photoresist will result in complete loss of the mask resist layer before the completion of etching the underlying dielectric layer, hence loss of critical dimension for anisotropic features. Comparing to example 1, this demonstrates that, without fluorocarbons such as C₄F₆, FTM by itself or diluted with an inert gas does not yield acceptable selective anisotropic etch performance.

**Table 3.**

| FTM/Ar Unpatterned Wafer Etch Results on GEC Reactor | | | | |
|---|---|---|---|---|
| FTM flow rate (sccm) | Ar flow rate (sccm) | SiO₂ etch rate (nm/min) | Photoresist etch rate (nm/min) | SiO₂/photoresist etch selectivity |
| 22.00 | 178 | 128 | 263 | 0.49 |
| 24.75 | 175.25 | 135 | 292 | 0.46 |
| 27.50 | 172.50 | 144 | 286 | 0.50 |
| 30.80 | 169.20 | 145 | 305 | 0.48 |

### Example 4: Patterned Wafer Etching Using FTM/C₄F₆/Ar Mixture on the GEC Reactor

A set of etch experiments with patterned wafers such as that depicted in Figure 2 were conducted on the GEC reactor. About 2 micrometer thick of SiO₂ film was deposited onto a unpatterned silicon wafer by plasma enhanced chemical vapor deposition (PECVD). The wafer was then coated with deep UV (DUV) photoresist and subsequently patterned with a set of vias with various diameters from 0.30 to 0.50 micrometers. The photoresist layer thickness before plasma etching was determined by scanning electron microscopy (SEM).

In addition to FTM/C₄F₆ ratio, C₄F₆ mole% was also varied. All the other processing conditions were the same as example 1. After plasma etching, the wafer was taken out of the reactor, broken into smaller pieces and analyzed by SEM. The SiO₂ etch rates were determined from the via depth in the SEM images, and the photoresist etch rates were determined from changes in the photoresist layer thickness from the SEM image. Table 4 lists the results from 0.35 micrometer via measurements.

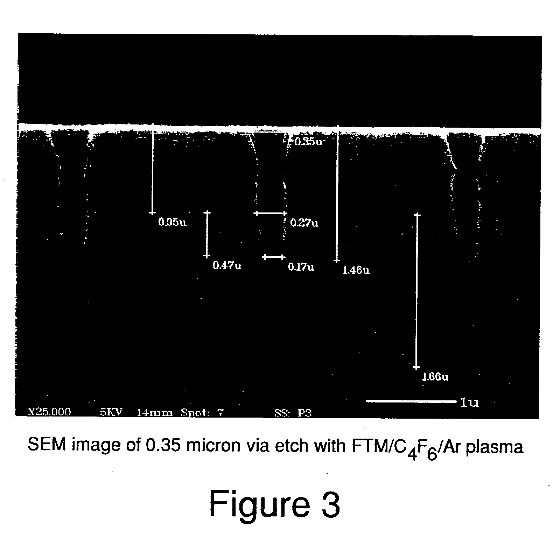

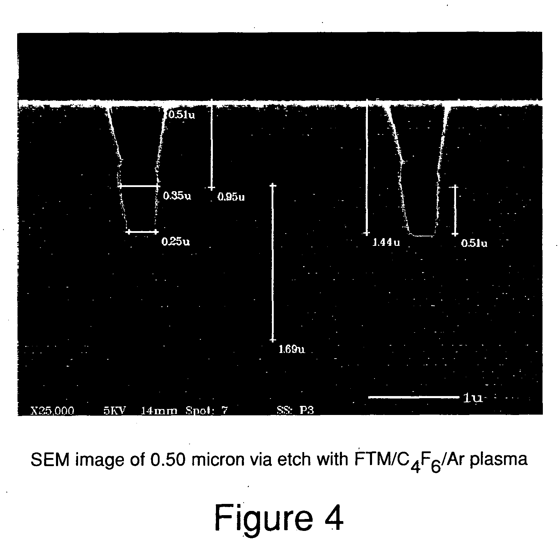

Referring to Table 4, it is apparent that the patterned wafer etch showed the same satisfactory results as the unpatterned wafer etch. This demonstrates the viability of the FTM/C₄F₆ chemistry for selective anisotropic etch of dielectric materials. Figures 3 and 4 show the SEM images of 0.35 and 0.50 micrometer vias, respectively, from Run #3 in Table 4.

It can be seen from Figures 3 and 4 that the FTM/C₄F₆ chemistry not only preserves the bulk thickness of the photoresist, but also preserves the critical dimensions of the mask patterns. In addition, good performance from small features such as 0.35 micron vias, to larger features such as 0.50 micron vias, and to open space unpatterned wafers show that there is no size dependence or microloading effect in FTM/C₄F₆ plasma etch. Examination of across wafer uniformity also shows good results, at least the same as the results from the conventional chemistry of O₂/C₄F₆ etched wafers.

**Table 4.**

| FTM/C₄F₆/Ar Patterned Wafer Etch Results on GEC Reactor | | | | | |
|---|---|---|---|---|---|
| Run# | C₄F₆ mole% | FTM/C₄F₆ molar ratio | SiO₂ etch rate (nm/min) | Photoresist etch rate (nm/min) | SiO₂/photoresist etch selectivity |
| 1 | 10 | 2.25 | 104 | 30 | 3.47 |
| 2 | 10 | 2.25 | 96 | 22 | 4.36 |
| 3 | 10 | 2.50 | 94 | 22 | 4.27 |
| 4 | 10 | 3.00 | 128 | 38 | 3.37 |
| 5 | 7.7 | 2.25 | 110 | 32 | 3.44 |

### Example 5. Patterned Wafer Etching Using O₂/C₄F₆/Ar Mixture on the GEC Reactor

For comparison, patterned wafer etch was performed using O₂/C₄F₆/Ar chemistry. Table 5 lists the processing recipe and results. This recipe was the optimized O₂/C₄F₆ recipe on our GEC plasma reactor. Other than the substitution of O₂ for FTM as the oxidizer, all other processing parameters are the same as example 4.

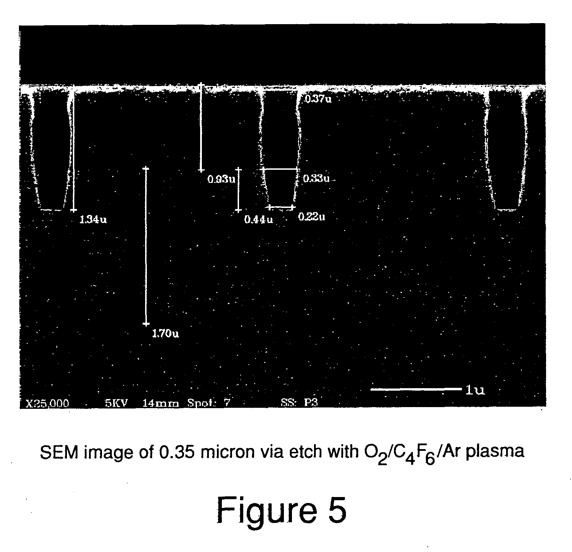

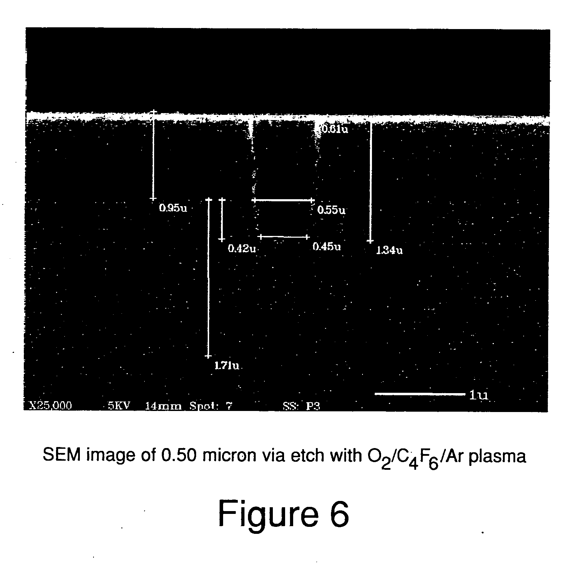

Consistent with the unpatterned wafer etch results, O₂/C₄F₆ patterned wafer etch also showed lower SiO₂ etch rate and lower SiO₂/photoresist selectivity than FTM/C₄F₆ chemistry. Figures 5 and 6 show the SEM images of 0.35 and 0.50 micrometer vias, respectively, from the O₂/C₄F₆ etch in Table 5.

Figures 5 and 6 show a shallower SiO₂ via depth. This again confirms that the conventional O₂/C₄F₆ chemistry produced lower SiO₂ etch rate and lower SiO₂/photoresist etch selectivity. Additionally, Figures 5 and 6 showed slight loss of the critical dimensions in the mask pattern.

**Table 5.**

| O₂/C₄F₆/Ar Patterned Wafer Etch Results on GEC Reactor | | | | |
|---|---|---|---|---|
| C₄F₆ mole% | FTM/C₄F₆ molar ratio | SiO₂ etch rate (nm/min) | Photoresist etch rate (nm/min) | SiO₂/photoresi st etch selectivity |
| 10 | 1.50 | 88 | 26 | 3.38 |

### Example 6. Unpatterned Wafer Etch Using FTM/C₄F₆/Ar Mixture on Applied Materials P-5000 Mark II Reactor.

The following example used a FTM/C₄F₆/Ar mixture to conduct etching within an Applied Materials P-5000 Mark II reactor. 200 mm wafers coated with SiO₂ or 193 nm photoresist materials are used in the evaluation. About 1 micrometer thick SiO₂ film was deposited by plasma enhanced chemical vapor deposition of tetraethylorthosilicate (TEOS). About 400 nm thick 193 nm photoresist was deposited by spin-on. The etch experiments were carried out at 35 mTorr chamber pressure, 50 Gauss magnetic field, and 1000 W RF power at 13.56 MHz (or about 3 W/cm² RF power density), which results in a dc self bias voltage of about -900 Volts. Table 6 provides the process recipes and results.

The advantage of using FTM as the oxidizer in combination with C₄F₆ for selective anisotropic dielectric etch is also clearly shown in the commercial Applied Materials P-5000 Mark II reactor.

**Table 6.**

| Unpatterned Wafer Etch Using FTM/C₄F₆/Ar on Applied Materials P-5000 Mark II reactor | | | | | |
|---|---|---|---|---|---|
| C₄F₆ mole% | FTM/C₄F₆ molar ratio | Total flow rate (sccm) | SiO₂ etch rate (nm/min) | Photoresist etch rate (nm/min) | SiO₂/photore sist etch selectivity |
| 10 | 1.25 | 175 | 328 | 55 | 6.01 |
| 13 | 1.25 | 175 | 326 | 50 | 6.51 |
| 13 | 1.25 | 150 | 336 | 55 | 6.11 |

### Comparative Example 7. Unpatterned Wafer Using FTM/Ar Mixture on Applied Materials Mark II Reactor

Similar to comparative example 3 performed on the GEC reactor, comparative experiments using FTM without C₄F₆ were conducted on the commercial Applied Materials P-5000 Mark II reactor. The recipe and results are listed in Table 7.

Again, the synergistic effect between FTM and C₄F₆ is confirmed. Without C₄F₆, the FTM/Ar mixture showed nearly 50% reduction in SiO₂ etch rate, yet five times increase in photoresist etch rate, resulting in a ten times decrease in SiO₂/photoresist etch selectivity. Thus, without C₄F₆, FTM cannot be used as a viable gas for selective anisotropic etch of dielectric materials.

It is believed that hypofluorites, fluoro-peroxides, and/or fluoro-trioxides alone cannot form a fluorocarbon polymer film to protect the photoresist or mask materials. Rather, hypofluorites, fluoro-peroxides, and/or fluoro-trioxides alone result in non-selective etch of both the photoresist and the dielectric materials, as shown in comparative examples 3 and 7. Thus, it is believed that the synergistic effects of hypofluorites, fluoro-peroxides, and/or fluoro-trioxides interacting with fluorocarbons can produce the benefits of higher etch rate of dielectric materials while maintaining a higher etch selectivity of the dielectric material over the photoresist material.

**Table 7.**

| Unpatterned Wafer Etch Using FTM/Ar Mixture on Applied Materials P-5000 Mark II Reactor | | | | |
|---|---|---|---|---|
| FTM flow rate (sccm) | Ar flow rate (sccm) | SiO₂ etch rate (nm/min) | Photoresist etch rate (nm/min) | SiO₂/photoresist etch selectivity |
| 26 | 124 | 163 | 268 | 0.61 |

### Example 8. Patterned Wafer Etch using FTM/C₄F₆/Ar Mixture on Applied Materials P-5000 Mark II Reactor.

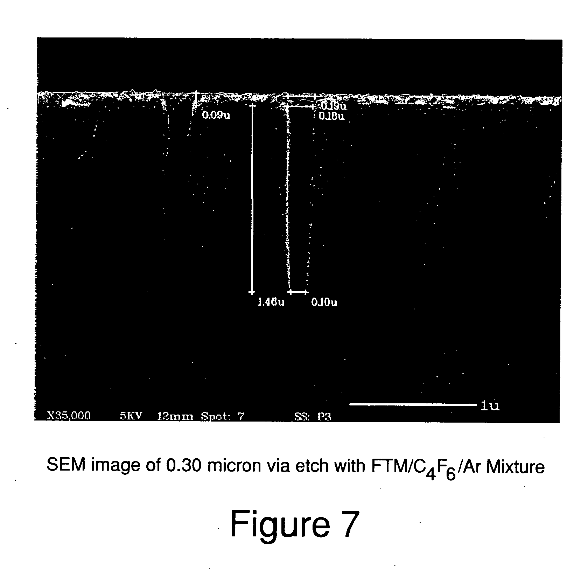

The following example was conducted in accordance with the method of example 6 using the following process recipe: 25 sccm FTM, 20 sccm C₄F₆, 155 sccm Ar, 35 mTorr chamber pressure, 50 Gauss magnetic field, 1000 W RF power, and 8 Torr He backside cooling pressure. Figure 7 provides an SEM image of a cross section of the etched wafer. As shown in Figure 7, the etch profile is improved from the etch profiles in Figures 3 through 6. This may be due to the reactor used.

While the invention has been described in detail and with reference to specific examples thereof, it will be apparent to one skilled in the art that various changes and modifications can be made therein without departing from the spirit and scope thereof.

## Claims

1. A mixture for etching a dielectric material in a layered substrate, the mixture comprising:
a fluorocarbon; and
a fluorine-containing oxidizer selected from the group consisting of a hypofluorite, a fluoroperoxide, a fluorotrioxide, and combinations thereof.

2. The mixture of claim 1 further comprising an inert diluent gas.

3. The mixture of claim 2 wherein the inert diluent gas is at least one selected from the group consisting of argon, neon, xenon, helium, nitrogen, krypton, and combinations thereof.

4. The mixture of claim 2 wherein the mixture comprises from 0.1 to 99 % by volume of the inert diluent gas.

5. The mixture of claim 1 wherein the fluorocarbon is at least one selected from the group consisting of perfluorocarbon, hydrofluorocarbon, oxyhydrofluorocarbon, oxyfluorocarbon, and combinations thereof.

6. The mixture of claim 5 wherein the fluorocarbon is at least one perfluorocarbon selected from the group consisting of tetrafluoromethane, trifluoromethane, octafluorocyclobutane, octafluorocyclopentene, hexafluoro-1,3-butadiene, and combinations thereof.

7. The mixture of claim 6 wherein the perfluorocarbon is hexafluoro-1,3-butadiene.

8. The mixture of claim 5 wherein the fluorocarbon is at least one hydrofluorocarbon.

9. The mixture of claim 9 wherein the fluorocarbon is at least one oxyhydrofluorocarbon.

10. The mixture of claim 5 wherein the oxyhydrofluorocarbon is at least one selected from the group consisting of perfluorocyclopentene oxide, hexafluoro-cyclobutanone, hexafluorodihydrofuran, hexafluorobutadiene epoxide, tetrafluorocyclobutanedione perfluorotetrahydrofuran (C₄F₈O), hexafluoropropylene oxide (C₃F₆O), perfluoromethylvinyl ether (C₃F₆O), and combinations thereof.

11. The mixture of claim 1 wherein the fluorine-containing oxidizer is a hypofluorite having the formula CₓH_{y}F_{z}(OF)ₙOₘ, wherein x is a number ranging from 0 to 8, y is a number ranging from 0 to 17, z is a number ranging from 0 to 17, n is 1 or 2, and m is 0, 1, or 2.

12. The mixture of claim 1 wherein the fluorine-containing oxidizer is a fluoroperoxide selected from the group consisting of difluoro-peroxide, fluoro-trifluoromethyl-peroxide, bis-trifluoromethyl peroxide, pentafluoroethyl-trifluoromethyl-peroxide, bis-pentafluoroethyl-peroxide, difluorodioxirane, bis-trifluoromethyl peroxydicarbonate, fluoroformyl trifluoromethyl peroxide, bis-fluoroformyl-peroxide, and combinations thereof.

13. The mixture of claim 1 wherein the fluorine-containing oxidizer is a fluorotrioxide selected from the group consisting of bis-trifluoromethyl-trioxide, fluorotrifluoromethyl-trioxide, fluoroformyl trifluoromethyl-trioxide, and combinations thereof.

14. The mixture of claim 1 wherein a ratio by volume of the fluorine-containing oxidizer to the fluorocarbon is from 0.1:1 to 20:1.

15. The mixture of claim 1 wherein the mixture comprises 1 to 99% by volume of the fluorine-containing oxidizer.

16. The mixture of claim 1 wherein the mixture comprises from 1 to 99% by volume of the fluorocarbon.

17. The mixture of claim 1 wherein the dielectric material is at least one selected from the group consisting of silicon, silicon-containing compositions, silicon dioxide (SiO₂), undoped silicon glass (USG), doped silica glass, silicon and nitrogen containing materials, organosilicate glass (OSG), organofluoro-silicate glass (OFSG), low dielectric constant materials, polymeric materials, porous low dielectric constant materials, and combinations thereof.

18. A mixture for etching a dielectric material in a layered substrate comprising: a fluorocarbon and a hypofluorite.

19. A mixture for etching a dielectric material in a layered substrate comprising: a fluorocarbon and a fluoroperoxide.

20. A mixture for etching a dielectric material in a layered substrate comprising: a fluorocarbon and a fluorotrioxide.

21. A method for the removal of a portion of a dielectric material from a layered substrate, the method comprising:
placing the layered substrate within a reaction chamber;
providing a gas mixture comprising a fluorocarbon gas and an oxidizer gas selected from the group consisting of a hypofluorite, a fluoroperoxide, a fluorotrioxide, and combinations thereof;
applying energy to the gas mixture to form active species; and
contacting the layered substrate with the active species wherein the active species at least partially react with and remove the portion of the dielectric material.

22. The method of claim 21 wherein the gas mixture has a pressure ranging from 0.1 to 10,000 mTorr.

23. The method of claim 21 wherein the flow rate of the gas mixture ranges from 10 to 50,000 standard cubic centimeters per minute (sccm).

24. The method of claim 21 wherein the gas mixture is provided through at least one method selected from the group consisting of conventional cylinders, safe delivery systems, vacuum delivery systems, solid-based generators, liquid-based generators, point of use generators, and combinations thereof.

25. The method of claim 21 wherein the energy source in the applying step is at least one selected from the group consisting of α-particles, β-particles, γ-rays, x-rays, high energy electron, electron beam sources, ultraviolet light, visible light, infrared light, microwave, radio-frequency wave, thermal energy, RF discharge, DC discharge, arc discharge, corona discharge, sonic energy, ultrasonic energy, megasonic energy, and combinations thereof.

26. A method for etching at least a portion of a dielectric material from a layered substrate comprising: contacting the layered substrate with active species of a mixture comprising a fluorocarbon selected from the group consisting of a perfluorocarbon, a hydrofluorocarbon, an oxyfluorocarbon, a oxyhydrofluorocarbon, and combinations thereof, and a fluorine-containing oxidizer selected from the group consisting of a hypofluorite, a fluoroperoxide, a fluorotrioxide, and combinations thereof wherein the active species of the mixture at least partially react with and remove the at least a portion of the dielectric material.
